# EUROPEAN PATENT APPLICATION

(11) **EP 4 446 479 A1**
(43) Date of publication of application: **16.10.2024**
(21) Application number: 22903530.8
(22) Date of filing: 07.12.2022
(51) Int. Cl.: C30B 15/00, C30B 15/20

(54) **CRYSTAL GROWTH METHOD, AND CRYSTAL GROWTH DEVICE**

(30) Priority: 08.12.2021 CN 202111487322; 08.12.2021 CN 202123056897 U
(71) Applicant: Beijing Hamamatsu Photon Techniques Inc., Beijing 100070 (CN); Hamamatsu Photonics K.K., Hamamatsu-shi, Shizuoka 435-8558 (JP)
(72) Inventor: HAN, Yongfei, Beijing 100070 (CN); WANG, Xin, Beijing 100070 (CN); LIU, Pengtao, Beijing 100070 (CN)
(74) Representative: Grünecker Patent- und Rechtsanwälte PartG mbB
(86) International application number: PCT/CN2022/137302
(87) International publication number: WO 2023/104109

(57) **Abstract**

A crystal growth method comprises: in a process of growing a crystal by using a pulling method, controlling an induction coil to move downwards with respect a crucible, wherein the induction coil moves with an acceleration after the crystal enters an equal-diameter stage, and the moving speed of the induction coil tends to continuously increase during the entire moving process of the induction coil. According to the crystal growth method, a change in a temperature gradient of a crystal growth interface caused by the internal temperature distribution of the crucible can be compensated, a continuous and stable temperature field environment is provided for crystal growth, and defects generated during a crystal growth process are reduced.

## Description

### RELATED APPLICATIONS

This application claims priority on the basis of Patent Application No.202111487322.X and Patent Application No.202123056897.4 filed in China on December 8, 2021, which are incorporated herein by reference.

### TECHNICAL FIELD

The present disclosure relates to the field of crystal growth, and in particular to a crystal growth method, and a device for crystal growth.

### BACKGROUND

A pulling method for crystal growth, which is a traditional melt growth method, is often used for crystalline materials having high melting points that are not volatile. The pulling method for crystal growth mainly includes the following steps: 1. material melting, wherein raw materials in a metal crucible are melted into a melt by heating the crucible by utilizing the eddy current effect to induce heat via coils with medium frequency currents; 2. crystal introduction, wherein oriented seed crystals are inserted into the melt to guide the directionality of melt crystallization; 3.shoulder extending, wherein the diameter of the crystal is gradually enlarged by accelerating a crystal crystallization speed by controlling a heating power or a melt temperature; 4. equal-diameter stage, wherein a crystal blank is enabled to be an uniform cylinder by controlling a crystal growth rate; and 5. finishing, wherein after the equal-diameter part of the growth is completed, the crystal growth rate is reduced to reduce the diameter of the crystal blank until it is removed from the melt, and the crystal blank is removed after cooling.

A relatively stable temperature field condition (i.e., a stable interface temperature, etc.) is required at the crystal growth interface during the crystal growth by a pulling method. If a temperature field condition is unstable, macroscopic defects can be caused, such as inclusions, clouds and bubbles inside the crystals.

During uniform crystal growth, the liquid surface of the melt in the crucible drops at a uniform rate and the temperature above the liquid surface changes. That is, during the crystallization process, the temperature of the growth interface during the crystallization process is different from that of the growth interface at the beginning of the crystallization as the liquid surface drops.

In the prior art, solutions are disclosed in which heating coils move with the descent of the liquid surface of the melt. For example, Patent Document 1 describes a method of moving heating coils downwards with respect to a crucible in such a way that the center of the heating coils is consistent with the center of the liquid melt inside the crucible. Patent Document 2 describes a method of moving heating coils downwards with respect to a crucible at an even speed of 15% to 25% of the descending speed of the melt in the crucible.

### Prior Art

Patent Document 1: JP A1979-9174
Patent Document 2: JP A1981-54299

### SUMMARY

### Technical Problem to be Solved by the Disclosure

However, in the above mentioned prior art, the effect to reduce crystal defects is not desired, because only the influence of the change in the relative position of the heating coils with respect to the liquid surface of the melt on the temperature field of the growth interface is considered, without considering the influence of the temperature distribution inside the crucible on the temperature field of the growth interface.

The present disclosure is provided for the above technical problem, and aims to provide a crystal growth method and device, and a crystal, to solve the problem of macroscopic defects such as inclusions, clouds, bubbles, etc. inside crystals due to the change in temperature field conditions during the crystal growth in the pulling method in the prior art.

### Solutions for Solving the Problem

In an aspect of the present disclosure, a crystal growth method comprises: in a process of growing a crystal by using a pulling method, controlling an induction coil to move downwards with respect a crucible, wherein: the induction coil moves with an acceleration after the crystal enters an equal-diameter stage, and the moving speed of the induction coil tends to continuously increase during the entire moving process of the induction coil.

In the crystal growth method according to an aspect of the present disclosure, by the trend to continuously increase the speed of the induction coil, the change in the temperature gradient at the crystal growth interface can be compensated, in which the change is resulted from the temperature distribution in the crucible, so that the temperature field during the crystal growth process is stabilized, thereby reducing defects generated during the crystal growth process.

In the crystal growth method of the present disclosure, the induction coil moves downwards with respect to the crucible with a variable acceleration during the entire moving process of the induction coil.

In the crystal growth method of the present disclosure, alternatively, the induction coil moves downwards with respect to the crucible with a constant acceleration during the entire moving process of the induction coil.

In the crystal growth method of the present disclosure, alternatively, a distance or time for which the induction coil moves with respect to the crucible is divided into a plurality of target sections in advance, and when the distance or time for which the induction coil moves with respect to the crucible corresponds to a target section, the induction coil is controlled to move at a constant speed corresponding to each of the target sections, wherein each of the target sections corresponds to a different speed, and a target section arranged later has a corresponding speed greater than that of a target section arranged earlier. In this case, the moving speed of the induction coil is gradually increased so as to meet the gradually increased compensation requirement of the temperature gradient with the descent of the liquid surface, so that the temperature field during the crystal growth process is stabilized, thereby reducing defects generated during the crystal growth process.

In the crystal growth method of the present disclosure, alternatively, a distance or time for which the induction coil moves with respect to the crucible is divided into a plurality of target sections in advance, and when the distance or time for which the induction coil moves with respect to the crucible reaches a target section, the induction coil is controlled to move with uniform acceleration at the acceleration corresponding to the target section, wherein each of the target sections corresponds to a different acceleration.

In the crystal growth method of the present disclosure, alternatively, the target section arranged later has a corresponding speed greater than that of the target section arranged earlier. As a result, the temperature gradient change for different locations of the crucible (especially the bottom of the crucible) can be better adapted, so that the temperature field during the crystal growth process can be stabilized, thereby reducing defects generated during the crystal growth process.

In the crystal growth method of the present disclosure, alternatively, the induction coil moves with respect to the crucible at a speed greater than or equal to 0.001 mm/h and less than or equal to 0.1 mm/h.

In the crystal growth method of the present disclosure, alternatively, the position of the liquid surface of the raw-material melt of the crystal with respect to the bottom of the crucible when the induction coil begins to move is set as an initial position of the liquid surface, an acceleration of the induction coil is set according to the initial position of the liquid surface, and the higher the initial position of the liquid surface is, the greater the acceleration is. Depending on crystal requirements (e.g., a crystal type, or length), it may be possible that the initial positions with respect to a bottom of a crucible for crystal growth are different. By differently setting the coil acceleration corresponding to the initial position of the liquid surfaces, the temperature gradient at different initial position of the liquid surfaces in the crucible can be better matched, thereby reducing defects generated during the crystal growth process.

In the crystal growth method of the present disclosure, alternatively, the acceleration of the induction coil is set according to the distance between the top of the induction coil and the liquid surface of the raw-material melt of the crystal when the induction coil begins to move, and the greater the distance is, the smaller the acceleration is. The initial positions of the coil (i.e. the distance between the coil and the liquid surface at the beginning of its moving) may be different depending on actual crystallization needs. By setting different coil acceleration corresponding to the initial position of the coil, the temperature gradients at different initial coil positions can be better matched, thereby reducing defects generated during the crystal growth process.

Another aspect of the present disclosure relates to a device for crystal growth comprising: a growth furnace, having a growth furnace cavity within it; a crucible, provided within the growth furnace cavity, which is capable of holding a crystal raw material; an induction coil provided within the growth furnace cavity and surrounding the exterior of the crucible; and an induction coil drive mechanism connected to the induction coil to drive the induction coil to move downwards with respect to the crucible during crystal growth, wherein the induction coil moves with an acceleration after the crystal enters an equal-diameter stage, and the moving speed of the induction coil tends to continuously increase during the entire moving process of the induction coil.

In the device for crystal growth of the present disclosure, alternatively, the induction coil drive mechanism comprises: a holder, a micro motion platform, and a motion mechanism; the holder is provided below the induction coil, one end of the holder is connected to the induction coil, and the other end is connected to the micro motion platform by passing through the bottom of the growth furnace; wherein the bottom of the growth furnace is provided with an opening for the holder to pass through; the micro motion platform is provided below the growth furnace, one side of the micro motion platform is connected to the holder, and the other side is connected to the motion mechanism; the motion mechanism is provided below the micro motion platform, and is capable of driving moving of the micro motion platform, and when the micro motion platform moves, it is capable of driving the moving of the holder and the induction coil connected to the holder.

In the device for crystal growth of the present disclosure, alternatively, the motion mechanism is connected to the micro motion platform by a transmission mechanism.

In the device for crystal growth of the present disclosure, alternatively, the device for crystal growth further comprises: a heat-preservation furnace chamber, provided within the growth furnace cavity, the crucible is provided within the heat-preservation furnace chamber, and the induction coil surrounds the exterior of the heat-preservation furnace chamber.

Another aspect of the present disclosure provides a radiation detector comprising: a substrate; a scintillator disposed on the substrate; and a light detector for detecting the scintillation light emitted from the scintillator due to irradiation by radiation, wherein the scintillator is obtained by cutting and grinding a crystal produced by the above crystal growth methods.

Another aspect of the present disclosure provides a method of producing a scintillator for a radiation detector, comprising: a step of obtaining a crystal blank, wherein the crystal blank is obtained according to any one of the above crystal growth methods; a step of cutting, wherein a portion of the crystal blank having a uniform diameter is selected and cut to form one or more crystals having desired shapes; and a step of grinding, wherein one or more crystals obtained in the cutting process are ground and polished, thereby obtaining scintillator body for the radiation detector.

### Effect of the Disclosure

According to the present disclosure, the crystal growth method and device, and crystal can be provided, which can solve the problem of macroscopic defects such as inclusions, clouds, bubbles, etc. inside crystals due to the change in temperature field conditions during the crystal growth in the pulling method in the prior art.

### BRIEF DESCRIPTION OF THE DRAWINGS

Fig. 1 is a schematic diagram schematically illustrating the structure of the device for crystal growth of the present disclosure.
Fig. 2 is a schematic diagram schematically illustrating the state of the induction coil in the device for crystal growth of the present disclosure after moving.
Fig. 3 is a schematic diagram schematically illustrating a longitudinal temperature distribution within a crucible.
Fig. 4 is a schematic diagram schematically illustrating the crystal growth method of the present disclosure.
Fig. 5 is a graph for illustrating the relation between a moving speed of an induction coil and a temperature gradient at a crystal growth interface.
Fig. 6 schematically illustrates a speed variation curve of an induction coil according to a first embodiment.
Fig. 7 schematically illustrates a speed variation curve of an induction coil according to a second embodiment.
Fig. 8 schematically illustrates a speed variation curve of an induction coil according to a third embodiment.
Fig. 9 schematically illustrates a speed variation curve of an induction coil according to a fourth embodiment.
Fig. 10 is a photograph obtained by laser scanning of a crystal blank.

### DETAILED DESCRIPTION

The technical solutions in the present disclosure will be described in detail below in reference with the figures. Obviously, embodiments described herein are only some embodiments of the present disclosure, rather than all the embodiments. All other embodiments, which are obtained by a person of ordinary skill in the art based on the embodiments in the present disclosure, fall within the scope of protection of the present disclosure.

The terms "first", "second", etc. in the description and claims of the present disclosure are used to distinguish similar objects, and are not to describe a particular order or sequence. It should be understood that such used terms may be interchanged in appropriate cases, so that embodiments of the present disclosure can be carried out in an order other than those illustrated or described herein. The objects distinguished by the "first" or "second" are generally of the same type with the number which is not limited, e.g., a first object which may be one, or more. In addition, "and/or" in the description and claims represents at least one of involved objects, and character "/" generally indicates that involved objects are in an "or" relation.

### [Device for Crystal Growth]

The device for crystal growth of the present disclosure is illustrated before illustrating the crystal growth method of the embodiment of the present disclosure,.

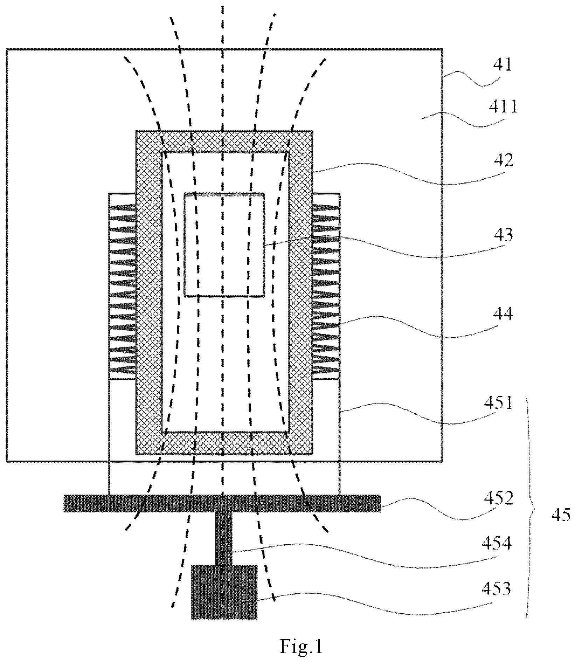

Referring to Fig. 1, the device for crystal growth of the present disclosure comprises: a growth furnace 41 having a growth furnace cavity 411 within it; a crucible 43, provided within the growth furnace cavity 411, and holding crystal raw materials therein; an induction coil 44, provided in the growth furnace cavity 411 and surrounding the exterior of the crucible 43; an induction coil drive mechanism 45, connected to the induction coil 44, and driving the induction coil 44 to move with respect to the crucible 43 during the crystal growth process. A magnetic field is generated, as shown by the dotted line in Fig. 1, when an electric current is flowed in the induction coil 44, and the crucible 43 is heated by the magnetic field.

In addition, the induction coil drive mechanism 45 may include a holder 451, a micro motion platform 452, and a motion mechanism 453; the holder 451 is provided below the induction coil 44, one end of which is connected to the induction coil 44, and the other end of which is connected to the micro motion platform 452 by passing through the bottom of the growth furnace 41; wherein the bottom of the growth furnace 41 is provided with an opening for the holder 451 to pass through.

The micro motion platform 452 may be provided below the growth furnace 41, one side of the platform is connected to the holder 451, and the other side is connected to the motion mechanism 453; the motion mechanism 453 may be provided below the micro motion platform 452, and may drive moving of the micro motion platform 452, and when the micro motion platform 452 moves, it may move the holder 451 and the inductive coil 44 connected to the holder 451.

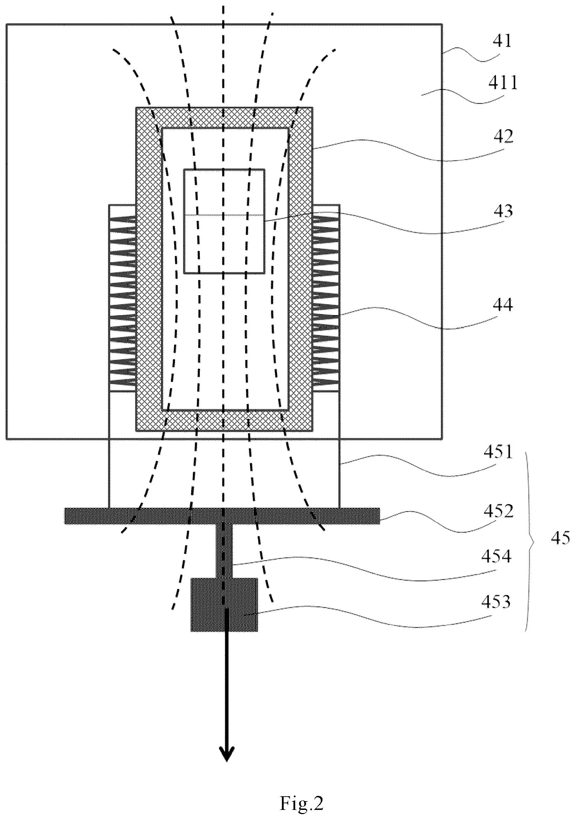

Fig. 2 shows the state after the inductive coil 44 moves, driving by the drive mechanism 45. In this case, as shown in Fig. 2, when the motion mechanism 453 moves, it drives moving of the micro motion platform 452 and the induction coil 44, thereby utilizing the motion mechanism 453 to drive the induction coil 44. Thus, the induction coil 44 can move at a tiny moving speed or acceleration by the micro motion platform 452 and motion mechanism 453.

The micro motion platform 452 may be set at the moving speed greater than or equal to 0.001 mm/h and less than or equal to 0.1 mm/h, thereby controlling the induction coil 44 to move at a speed ranging from 0.001 mm/h to 0.1 mm/h. The micro motion platform 452 may carry a certain weight to support the holder 451 and induction coil 44. The moving method for the induction coil 44 will be described in detail later.

In addition, the motion mechanism 453 and the micro motion platform 452 may be connected by a transmission mechanism 454. In this case, the motion mechanism 453 may drive moving of the micro-motion platform 452 and induction coil 44 via the transmission mechanism 454.

In addition, the device for crystal growth may also include: a heat-preservation furnace chamber 42 provided in the growth furnace cavity 411. The crucible 43 is provided in the heat-preservation furnace chamber 42, and the induction coil 44 surrounds the exterior of the heat-preservation furnace chamber 42. In this case, the heat-preservation furnace chamber 42 is fixed in the growth furnace cavity 411, having the effect of heat insulation. The crucible 43 is placed in the heat-preservation furnace chamber 42, and is a heating element of the crystal growth furnace 41 and a container for crystal raw materials. The induction coil 44 is located outside the heat-preservation furnace chamber and is fixedly connected to the holder, and can move downwards with respect to the crucible 43.

A fixing structure can be provided at a predetermined position in the heat-preservation furnace chamber 42, and the crucible 43 is fixed in the heat-preservation furnace chamber 42 by the fixing structure. In this case, the crucible 43 placed at the fixing position in the heat-preservation furnace chamber 42 and is stable during the crystal growth process, so as to avoid shaking which has an adverse effect on crystal growth. The crucible 43 is for example metal. In this case, the eddy current effect can be induced in the metal crucible within the magnetic field of the induction coil 44 to generate heat for crystal growth.

### [Temperature Distribution inside the Crucible]

The inventor investigates the temperature distribution inside the crucible during crystal growth.

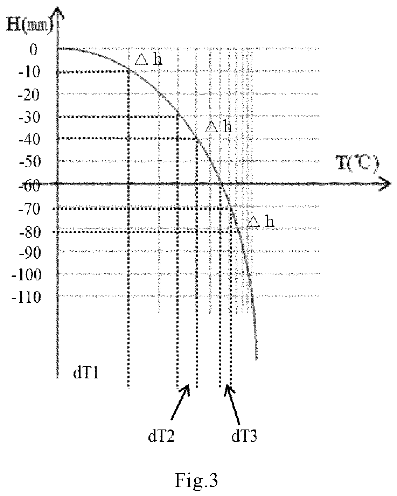

The inventor found that the temperature distribution inside the crucible during the crystal growth has a trend as shown in Fig. 3 when the induction coil does not move. In Fig. 3, the longitudinal axis represents different positions in the crucible in a longitudinal direction, where the scale 0 mm represents the top of the crucible, and the negative direction along the longitudinal axis (the direction opposite to the direction indicated by the longitudinal axis arrow) represents the direction toward the bottom of the crucible. The horizontal axis indicates the temperature inside the crucible, and the direction of the horizontal axis arrow indicates a temperature increase direction. As shown in Fig. 3, the temperature increases gradually from the top to the bottom of the crucible, with an overall parabolic variation. That is, the temperature gradient dT within certain height interval Δh (e.g. 10 mm) (=ΔT/Δh) gradually decreases. Specifically, the temperature gradient dTl within height Δh at the top of the crucible is greater than the temperature gradient dT2 within the height Δh at the middle part of the crucible, and the temperature gradient dT2 is greater than the temperature gradient dT3 within height Δh at the bottom of the crucible, i.e. dTl>dT2>dT3. That is, there is a significant change in the temperature gradient for different longitudinal positions in the crucible, in addition to different temperatures, i.e., the temperature gradient gradually decreases along the longitudinal direction from the top to the bottom of the crucible.

The inventor speculates that the main reasons for the temperature distribution inside the crucible shown in Fig. 3 during the crystal growth process are: (i) the uneven distribution of the magnetic field lines of the induction coil as a heater, and (ii) the heat accumulation inside the crucible. For above reason (1), the magnetic field lines of the induction coil are relatively sparse at both ends and relatively dense in the middle part, and the eddy current induction of the metal is more intensive in the area with denser magnetic field lines, thereby leading to a high temperature. In a typical pulling-method crystal growth process, the entire crucible is located at a middle-upper part of an induction coil as a heater. Since the magnetic field lines of the induction coil are relatively dense in the middle region, and become sparser upward from the region, the temperature in the metal crucible varies at different locations with respect to the induction coil. That is, a non-uniform temperature field distribution is generated in the metal crucible, wherein, generally, the temperature is relatively high at the middle and bottom parts of the crucible with the region having dense magnetic field lines, and the temperature is relatively low at the top of the crucible with the region having sparse magnetic field lines. For above reason (ii), the temperature at the bottom of the crucible is higher than that at the top of the crucible is cause by the fact that the heat inside the crucible accumulates at the bottom, and thus, the temperature at the bottom of the crucible is higher than that at the top of the crucible, and the temperature difference at the bottom of the crucible is relatively small. As a result, according to the distribution curve of the temperature inside the crucible, as the liquid surface of the melt inside the crucible drops, the temperature above the liquid surface increases, resulting in temperature field conditions at the growth interface being different from the initial temperature field conditions. Moreover, above reasons (1) and (ii) have particular obvious effects on the temperature field at the bottom of the crucible, as can be seen from Fig. 3, the temperature change is very small near the bottom of the crucible, with a temperature gradient close to 0.

In addition, as can be seen from Fig. 3, when crystallization is initiated and a liquid surface starts to drop, the temperature gradient at a growth interface is smaller than the initial temperature gradient at the beginning of the crystallization, but a relatively large temperature gradient can still be maintained. With the gradual descent of the liquid surface of the melt, the difference between the temperature gradient at the growth interface and the initial temperature gradient gradually increases, and the difference is significant when the liquid surface drops to the middle or the bottom of the crucible. Therefore, the temperature gradient compensation amount required for maintaining the initial temperature gradient increases with the descending of the liquid surface of the melt.

### [Crystal Growth Method]

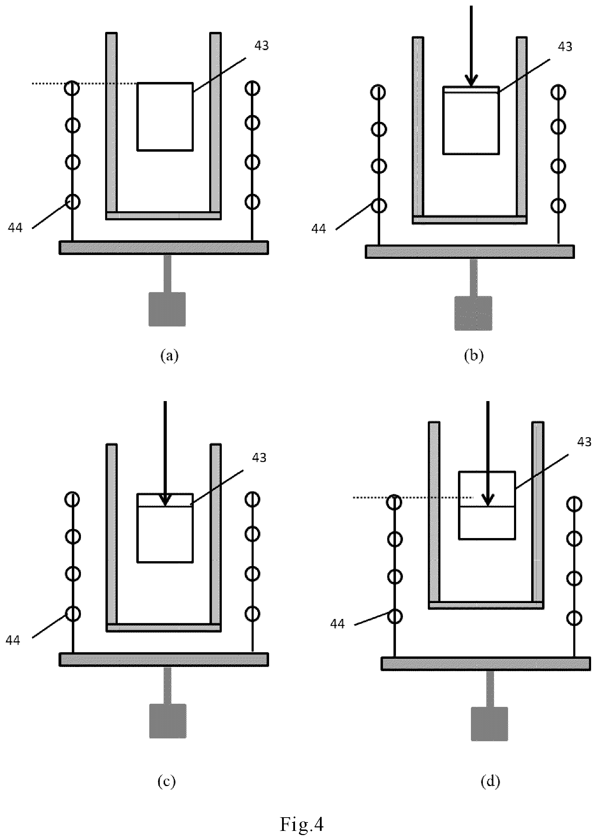

The crystal growth method of the present disclosure is described below with reference to Fig. 4. The crystal materials of the present disclosure can be, for example, YAG, YVO₄, LSO, LYSO, RGBS, BGO, GAGG, LiNbO₃, LiTaO₃, and the like.

The pulling method of the present disclosure for crystal growth mainly has the following steps:
a raw material preparation step in which based on a stoichiometric ratio, the weight of respective raw materials are calculated to prepare a certain weight of crystals, and each of the raw materials is weighted according to the calculated weight, mixed uniformly, and then pressed into ingots,
a furnace loading step in which after adjusting the heating coil to the specified position with respect to the crucible (as shown in (a) of Fig. 4), the ingots are loaded into the crucible, then the chamber of the crystal growth furnace is evacuated, and after the chamber is in a vacuum state, protective gas is fed into the chamber to prevent oxidizing of the metal crucible at a high temperature,
a raw material melting step in which a medium-frequency induction current is applied to the induction coil to inductively heat the crucible, thereby heating and melting the raw materials to form a melt,
a crystallization step in which the seed crystal is brought into contact with the melt, the current and position of the induction coil are adjusted, and crystal growth is performed on the seed crystal, and
a removal step in which the temperature in the crucible is slowly reduced to room temperature and a crystal blank is removed from the growth furnace.

Herein, in the crystallization step (i.e., the process of growing crystals using the pulling method) can include several stages.

The crystallization step includes a crystal introduction stage in which the seed crystal is brought into contact with the melt, the temperature of the melt is adjusted to obtain a suitable temperature, and the seed crystal is pulled upwards for crystal growth. Here, as shown in Fig. 4 (b), the liquid surface of the melt in the crucible starts to drop. The downward arrow in Fig. 4 represents the descending of the liquid surface of the melt.

The crystallization step includes a shoulder extending stage in which the temperature is further adjusted for the melt to accelerate the crystallization speed, so as to gradually increase the crystal diameter. As shown in Fig. 4 (c), the liquid surface of the melt in the crucible is further decreased.

The crystallization step includes a equal-diameter stage. The crystal growth enters the equal-diameter stage after the shoulder extending stage is ended when a crystal diameter reaches a set value. The crystal growth rate is controlled so that the crystal blanks are uniformly cylindrical. During the equal-diameter stage, the liquid surface of the melt drops significantly and the temperature gradient at the growth interface changes. In order to keep the temperature gradient at the crystal growth interface consistent with that in the initial state, the induction coil can be controlled to move downwards with respect to the crucible at a continuously increasing speed during this stage. The method of moving the induction coil and the definition of "continuously increasing speed" are described in detail later.

The step includes a finishing stage. After the crystal length reaches a set value during the equal-diameter stage, the equal-diameter stage is finished, and the coil descent is stopped (as shown in Fig. 4(d)). The melt temperature is adjusted again, and the crystallization speed is slowed down so that the diameter of the crystal gradually decreases until the crystal is separated from the melt.

Hereafter, the moving method of the coil in the above crystal growth method is illustrated.

### <Relation between the Moving of the Coil and Temperature Gradient>

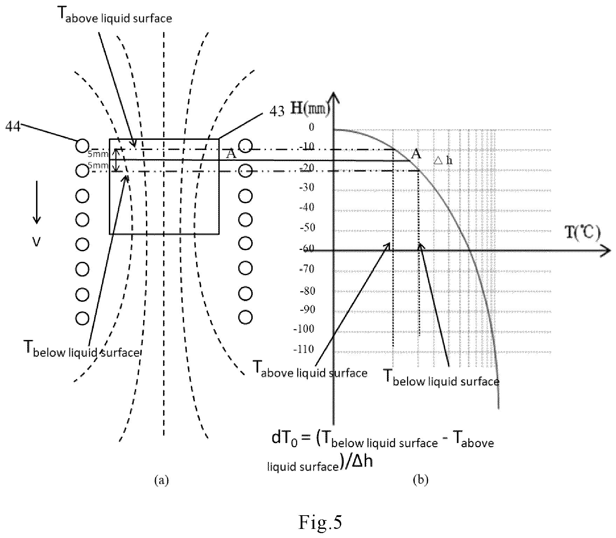

Hereafter, the influence of the moving method of the coil on the temperature gradient at the liquid surface of the melt is described with reference to Fig. 5. Fig. 5 (a) shows an example of the relative position of the induction coil, crucible, and the liquid surface of the melt during the crystal growth process. Fig. 5 (b) is a view in which the temperature and temperature gradient near the liquid surface of the melt in Fig. 5 (a) are labeled in conjunction with the temperature distribution curve in Fig. 3. As shown in Fig. 5 (a), the induction coil 44 is the heat source for the crucible 43, and the magnetic field lines of the induction coil 44 are distributed more sparsely above the liquid surface A than below the liquid surface A. The temperature at 5 mm above the liquid surface A is set to T_{above liquid surface} and the temperature at 5 mm below the liquid surface A is set to T_{below liquid surface}. Due to the distribution density of the magnetic field lines of the induction coil 44, the temperature at 5 mm above the liquid surface is lower than the temperature at 5 mm below the liquid surface, i.e., T_{above liquid surface} < T_{below liquid surface}. The temperature gradient at the liquid surface A is set to be dT₀, in which dT₀ =(T_{below liquid surface} - T_{above liquid surface})/Δh (here, Δh=10 mm).

When the induction coil 44 moves downwards at a speed v, the magnetic field lines of the coil change accordingly, i.e., the magnetic field lines above and below the liquid surface A become sparse, and therefore, T_{below liquid surface} and T_{above liquid surface} both decrease. The temperature change at 5 mm above the liquid surface A is labelled as ΔT_{above liquid surface} and the temperature change at 5 mm below the liquid surface A is labelled as ΔT_{below liquid surface}. Since the magnetic field lines of the induction coil 44 become sparse as they move away from the center, the temperature drop is faster at the liquid surface A which is further away from the center of the coil, i.e., ΔT_{above liquid surface} - ΔT_{below liquid surface} > 0. And, the faster the speed v, the larger the value of ΔT_{above liquid surface} - ΔT_{below liquid surface} is.

The temperature gradient at the liquid surface A is set as dTv when the coil descends with the speed v, dTv = [(T_{below liquid surface} - ΔT_{below liquid surface})-( T_{above liquid surface} - ΔTabove _{liquid surface})]/Δh = dT₀ + (ΔT_{above liquid surface} - ΔT_{below liquid surface})/Δh. Since ΔT_{above liquid surface} - ΔT_{below liquid surface} > 0, the temperature gradient dT at the liquid surface A is compensated (increased) by the value of (ΔT_{above liquid surface} - ΔT_{below liquid surface})/Δh when the coil descends at the speed v. Moreover, the faster the speed v is, the larger the compensation value is.

Based on the above principle, the inventors of the present disclosure finds: given the temperature curve inside the crucible shown in Fig. 3, if the induction coil descends at a constant rate as in the prior art, the temperature drop above the liquid surface is excessively rapid at the beginning section of the liquid surface drop, i.e., at the top region of the crucible, destroying the original temperature gradient (i.e., excessively large temperature gradient compensation due to the moving of the induction coil) or the temperature of the melt above the liquid surface decreases too slowly when the liquid surface decreases to the middle or bottom part of the crucible, so the temperature gradient required for crystal growth is not reached (i.e., too small temperature gradient compensation due to the moving of the induction coil).

Based on the above research, the present disclosure proposes a method of controlling an induction coil to move downwards with respect to a crucible, wherein the temperature gradient change is compensated by moving the induction coil, so that the temperature gradient required for crystal growth can be maintained in the crucible from the initial stage of the descent of the liquid surface of the melt, to the time when the liquid surface drops to the middle and the bottom of the crucible, avoiding the defects during the crystal growth process.

### < The Moving Method of the Coil>

### (First Embodiment)

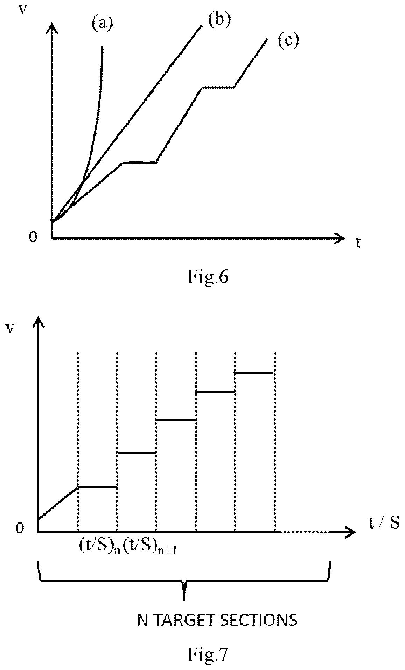

In a first embodiment, as shown in the speed curves (a), (b), and (c) of Fig. 6, the induction coil moves with an acceleration after the crystal enters the equal-diameter stage, and the moving speed of the induction coil tends to continuously increase during the entire moving process of the induction coil. Here, two situations are included by the expression that "the induction coil moves with an acceleration after the crystal enters the equal-diameter stage": (i) after the crystal enters the equal-diameter stage, the induction coil starts to move with an acceleration (acceleration >0) (i.e., the acceleration when the coil begins to move is greater than 0); and (ii) the induction coil has already started to move before the crystal enters the equal-diameter stage, and the coil is controlled to continue to move with an acceleration (acceleration > 0) after the crystal enters the equal-diameter stage.

Furthermore, optionally, during the entire moving process of the induction coil, the induction coil moves with respect to the crucible at a speed greater than or equal to 0.001 mm/h and less than or equal to 0.1 mm/h. However, it should also be understood that the initial speed when the induction coil begins to move can also be set to 0 mm/h.

After the end of the crystal growth via a pulling method, the crystal generated during the equal-diameter stage are mainly taken. Hence, it is more important to stabilize the temperature field during the equal-diameter stage than other crystal growth stages in the pulling method. On the other hand, the liquid surface of the melt starts to change significantly after the crystal enters the equal-diameter stage, i.e., the temperature gradient starts to change significantly. Therefore, in a first embodiment, the induction coil may start to move with an acceleration after entering the equal-diameter phase to adjust the position of the metal crucible with respect to the induction coil in order to adjust the temperature above the liquid surface of the melt in the crucible. As should be understood, the induction coil may also move downwards with respect to the crucible during other crystal growth stages in the pulling method, e.g. the shoulder extending stage, where the temperature above the liquid surface of the melt increases due to a drop of the liquid surface in the crucible, and the moving speed of the induction coil is then controlled to increase continuously as the induction coil has an initial speed when the crystal enters the equal-diameter stage.

Here, two cases are included by the expression that "the moving speed of the induction coil tends to continuously increase": continuously increasing in the speed of the induction coil, i.e., the acceleration is always greater than 0 (see curves (a) and (b) in Fig. 6); and staged increase in the speed of the induction coil, i.e., a stage where the acceleration is equal to 0 (see curve (c) in Fig. 6) exists.

As shown by curve (a) in Fig. 6, during the entire moving process of the induction coil, the induction coil moves downwards with respect to the crucible with variable acceleration which is larger and larger. As shown by curve (b) in Fig. 6, during the entire moving process of the induction coil, the coil speed increases uniformly.

According to the moving method of the coil in the first embodiment, when the coil begins to move (i.e., when the liquid surface is at the top region of the crucible), the coil has a low speed, and the temperature gradient compensation due to the moving of the induction coil is small. Thereafter, the induction coil has the speed tending to increase continuously as the liquid surface drops, the temperature gradient compensation due to the moving of the induction coil becomes large, so as to satisfy the requirements for the temperature gradient compensation (i.e., the required temperature gradient compensation amount increases as the liquid surface drops). According to the moving method of the coil in the first embodiment, the temperature gradient can be kept for crystal growth from the initial stage of the descent of the liquid surface of the melt in the crucible, to the time when the liquid surface descends to the middle and the bottom of the crucible, stabilizing the temperature field during the crystal growth process to prevent defects generated during the crystal growth process.

Here, when the induction coil moves according to the curves (a) and (b) in Fig. 6, especially when the liquid surface is at the middle and the bottom of the crucible, the temperature gradient change can be better compensated for different positions in the crucible, maintaining the temperature gradient for crystal growth from the initial stage of the descent of the liquid surface of the melt in the crucible, to the time when the liquid surface descends to the middle and the bottom of the crucible.

### (Second Embodiment)

In the second embodiment, as shown in Fig. 7, a distance S or time t for which the induction coil moves with respect to the crucible is divided into N target sections in advance (N is an integer greater than 2). When the distance or time for which the induction coil moves with respect to the crucible reaches a target section (t/S)ₙ, the induction coil is controlled to move at a constant speed vₙ corresponding to the target section (t/S)ₙ, wherein each target section corresponds to a different speed, and a target section arranged later (t/S)ₙ₊₁ has a corresponding speed vₙ₊₁ greater than a speed vₙ of a target section arranged earlier (t/S)ₙ, wherein, the induction coil may be accelerated to v₁ at constant acceleration before or during a first target section.

In the moving method of the coil in the second embodiment, since a target section arranged later (t/S)ₙ₊₁ has a corresponding speed vₙ₊₁ greater than a speed vₙ of a target section arranged earlier (t/S)ₙ, the temperature gradient compensation generated by moving the induction coil becomes large, thus satisfying the temperature gradient compensation requirement (i.e., the required temperature gradient compensation amount increases with the drop of the liquid surface), stabilizing the temperature field during the crystal growth process to reduce defects generated during the crystal growth process.

In addition, as a variation example of the second embodiment, the distance or time for which the induction coil moves with respect to the crucible can also be monitored. When the distance or the time for which the induction coil moves reaches a predetermined condition, the speed of the induction coil is controlled to increase. Alternatively, each time when the distance or the time for which the induction coil moves with respect to the crucible is increased by a predetermined increment, the speed of the induction coil is controlled to increase by a predetermined increment. Here, preset conditions, preset thresholds, and preset increments may be set as any reasonable values as required, without limitation herein. Hence, the speed of the induction coil can be controlled to gradually increase to adapt to changes in the temperature difference at different positions of the crucible, stabilizing the temperature field during the crystal growth process to prevent defects generated during the crystal growth process.

### (Third Embodiment)

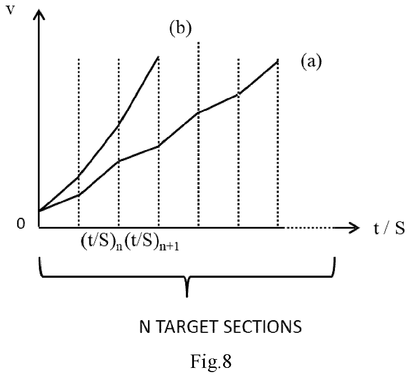

In the third embodiment, as shown in Fig. 8, the total distance S or the total time t for which the induction coil moves with respect to the crucible is divided into N target sections (N is an integer greater than 2). When the distance or time for which the induction coil moves with respect to the crucible reaches the target section (t/S)ₙ, the induction coil is controlled to move with uniform acceleration at the acceleration aₙ corresponding to the target section (t/S)n, wherein each of the target sections corresponds to different acceleration, i.e. the acceleration aₙ₊₁ corresponding to the target section (t/S)ₙ₊₁ is not equal to the acceleration aₙ corresponding to the target section (t/S)ₙ.

Here, the expression that the acceleration aₙ₊₁ corresponding to (t/S)ₙ₊₁ is not equal to the acceleration aₙ corresponding to the target section (t/S)ₙ means that the induction coil moves downwards with variable acceleration with respect to the crucible during the entire moving process of the induction coil. The third embodiment comprises: a case in which the acceleration gradually increases (i.e., aₙ₊₁>aₙ), as (b) in Fig. 8, and a case in which a target section that the acceleration decreases exists (i.e., aₙ₊₁<aₙ) as (a) in Fig. 8. However, in both of the above cases, as shown in Fig. 8, the acceleration is greater than 0 in all target sections, i.e., the speed of the induction coil is continuously increased. Therefore, the temperature gradient compensation due to the moving of the induction coil continuously increased, and satisfies the requirement for temperature gradient compensation (i.e., the amount of required temperature gradient compensation is increased with the drop of the liquid surface), stabilizing the temperature field during the crystal growth process to prevent defects generated during the crystal growth process.

As an example of the moving method of the induction coil in Fig. 8, the time for which the induction coil moves can be divided into a plurality of target sections by an interval of 25h (hours). In a first 25h target section, i.e., when the coil begins to move, the acceleration is a₁, 0<a₁<0.001 mm/h². After the first 25 h, the distance traveled by the coil is 0<sl<l mm. Then, in a second 25h target section, the acceleration for coil moving is adjusted to a₂, 0<a₂<0.005 mm/h², and after the second 25 h, the distance traveled by the coil is 1 mm<s2<3 mm. In a third 25h target section, the acceleration for coil moving is adjusted to a₃, 0.0001 mm<a₃<0.01 mm/h², and after the third 25 h, the distance traveled by the coil is 3 mm<s3<5 mm. In the fourth 25h target section, the acceleration for the moving of the coil is adjusted to a₄, 0.0005 mm/h²<a₄<0.01 mm/h², and the distance traveled by the coil is 5 mm<s4<9 mm. Then, a4 is kept until the end of crystal growth. By such controlled moving of the induction coil, the temperature field is stabilized during the crystal growth process to prevent defects generated during the crystal growth process.

In addition, the method of (b) of Fig. 8 where the acceleration is continuously increased is more effective than the method of (a) of Fig. 8, because the temperature gradient compensation is increased gradually to maintain the temperature gradient requirement for crystallization as the liquid surface drops, especially at the bottom of the crucible where the temperature gradient is close to 0. If the induction coil moves with continuously increased acceleration, the coil can have a relatively large moving speed when the liquid surface is close to the bottom of the crucible, so as to compensate for the relatively large temperature gradient difference required for the bottom of the crucible, so that the temperature field is still stabilized during the final phase of the crystal growth process to further prevent defects generated during the crystal growth process.

### (Fourth Embodiment)

In the fourth embodiment, given that the initial position of the liquid surface of the melt with respect to the bottom of the crucible when the induction coil begins to move may vary depending on a crystal type, a required crystal amount, etc., it is also possible to set a speed curve for the downward moving of the induction coil with respect to the crucible according to the actual temperature distribution near the growth interface, so that a temperature gradient similar to that in the initial state is always maintained during liquid surface drop, thereby improving the crystal quality.

In the fourth embodiment, the position of the liquid surface of the raw material melt of the crystal with respect to the bottom of the crucible when the induction coil begins to move can be set as the initial position of the liquid surface, and the acceleration of the induction coil is set according to the initial position, and the higher the initial position of the liquid surface is, the higher the acceleration is.

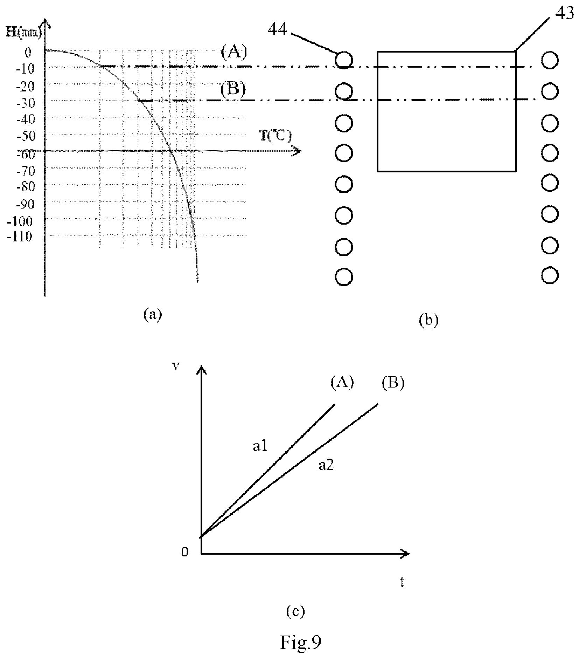

For example, as shown in Figs. 9 (a) ~ (c), in case (A), after the crystal A enters the equal-diameter stage, the initial position of the liquid surface of the melt is at (A) in Figs. 9 (a) and (b). Here, the induction coil is controlled to drop with respect to the crucible with uniform acceleration which is al, with the speed curve as shown in curve (A) in Fig. 9 (c). In case (B), after the crystal B enters the equal-diameter stage, the initial position of the liquid surface of the melt is at (B) in Fig. 9 (a) and (b). Here, the induction coil drops with respect to the crucible with uniform acceleration which is acceleration a2, with the speed curve shown in curve (B) in Fig. 9 (c). In both cases, regarding the initial position of the liquid surface of the melt, position (A) is higher than position (B), and the acceleration relation is al>a2. As shown in Fig. 9 (a), since initial position (A) is higher than initial position (B), the temperature gradient at initial position (A) is larger which need a larger required gradient compensation value. Therefore, by setting the acceleration al greater than the acceleration a2, the speed value of the speed curve (A) in Fig. 9 (c) is always greater than the speed value of the speed curve (B), so that the temperature gradient can be matched at different initial positions in the crucible, thus further reducing defects during the crystal growth process. In Fig. 9, an illustrative example is used in which the induction coil descents with uniform acceleration, and when the induction coil descends with variable acceleration, it is also possible to keep the acceleration al greater than the acceleration a2 during the entire descent process. In addition, as long as the speed value of the speed curve of the induction coil for the case with a high initial position of the liquid surface is always greater than that for the case with a low initial position of the liquid surface, the acceleration al and a2 can be appropriately set. Additionally, similarly, the acceleration of the induction coil may be set according to the distance between the top of the induction coil and the liquid surface position when the induction coil begins to move, and the larger the distance is, the smaller the acceleration is. When the distance between the top of the induction coil and the liquid surface is relatively large, the liquid surface is at a lower position, and by setting relatively small acceleration in this case, it is also possible to match the temperature gradient at different initial positions in the crucible, thereby further reducing the defects generated during the crystal growth process. Similarly, as long as the speed value of the speed curve of the induction coil in the above case with the small distance (the distance between the top of the induction coil and the liquid surface) is always greater than that in the above case with the large distance, the acceleration of both can be appropriately set.

### <Determination of Crystal Defects>

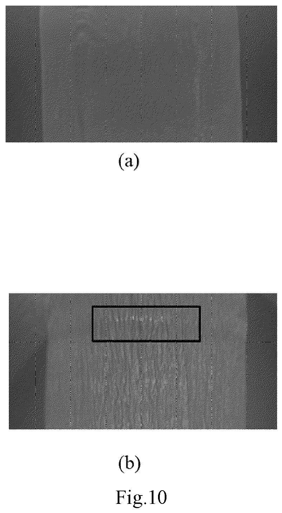

In the practical production, the crystal quality is evaluated by scanning crystal blanks by a laser beam. As shown in (b) in Fig. 10, the refraction of a laser beam is to show bright spots at defects when there are the defects such as cores and scattering particles inside the blanks. The laser beam moves in the same medium without refraction, and the overall brightness of the blanks is the same when there are no defects inside the blanks, as shown in (a) in Fig. 10.

### < Radiation Detector and Method for Producing Scintillator for the Detector>

A crystal is produced by the above crystal growth method according to the present disclosure, and can be further used to make the scintillator for radiation detectors.

The radiation detector of the present disclosure comprises, for example, a substrate; a scintillator provided on the substrate; and a light detector for detecting the scintillation light emitted from the scintillator due to irradiation by radiation, wherein the scintillator is obtained by cutting and grinding a crystal produced by any of the above-described crystal growth methods. The radiation detector according to the present disclosure can improve the accuracy of radiation detection.

The producing method of the scintillator for the radiation detector of the present disclosure may include:
(i) a step of obtaining a crystal blank, wherein the crystal blank is obtained according to any of the above-described crystal growth methods;
   a step of cutting, wherein a portion of the crystal blank having a uniform diameter is selected and cut to form one or more crystals having desired shapes; and
   a step of grinding, wherein one or more crystals obtained in the step of cutting are ground and polished, thereby obtaining one or more scintillator body for the radiation detector.

Additionally, after the grinding process, a plurality of crystals may also be arranged on a reflective layer to form a crystal array, thereby obtaining a scintillator array for the radiation detector. The reflective layer may, for example, comprise TiO₂, Ba₂SO₄, and the like.

### <Example>

Specific examples of the method for controlling an induction coil disclosed herein is described in detail below, and the quality of the crystal blanks of the specific examples is evaluated by the crystal quality evaluation method described above.

### (Example 1)

In example 1, a process of growing crystal LYSO (a lutetium yttrium oxyorthosilicate crystal) was performed according to the steps of the crystal growth method described above: raw material preparation, furnace loading, raw material melting, crystallization, and removal. In the following, the steps related to the moving of the coil are described.

In the furnace loading step, the upper edge of the heating coil was adjusted to be flush with the upper edge of the crucible (see the dotted line in Fig. 4 (a)). In the equal-diameter stage, the control coil was controlled to start moving with uniform acceleration with a moving speed of v = 0.0011 mm/h, i.e. the acceleration of 0.001 mm/h², in the direction opposite to the crystal pulling direction. At the finishing stage, after the crystal length in the equal-diameter stage was a set value, the descent of the coil was stopped.

The quality of the crystal after growth was evaluated by laser scanning of the crystal blank. The result shows that the crystal blank is complete and transparent, with no obvious defects such as inclusions, clouds, bubbles, etc. therein. In this way, it can be considered in example 1: during the process for controlling the downward moving of the induction coil with respect to the crucible, the coil is controlled to move with uniform acceleration with the acceleration a=0.001 mm/h², so that the temperature gradient for the crystal growth interface can be consistent with the temperature gradient in the initial state from the beginning of the descending of the liquid surface of the melt in the crucible, to the time when the liquid surface drops to the middle and the bottom of the crucible, so as to provide stable temperature field conditions for crystal growth, thereby reducing defects generated during the crystal growth process.

### (Example 2)

Except that the induction coil moves with gradually increased acceleration during the equal-diameter process, the conditions for the other crystal growth stages in example 2 are the same as that in example 1. Only the difference is explained, with the same portions of the conditions omitted herein.

After the crystal entered the equal-diameter stage, the time for which the induction coil moves was divided into a plurality of target sections by an interval of 25h. In the first 25h target section, i.e., when the coil begins to move, the acceleration was a1, a1 = 0.001 mm/h² for the first 25h. Then, in the second 25h target section, the acceleration of the coil was adjusted to a2, a2 = 0.003 mm/h², for the second 25 h. In the third 25h target interval, the acceleration of the coil was adjusted to a3, a3 = 0.005 mm/h² for the third 25 h. In the fourth 25 h, the acceleration of the coil was adjusted to a4, a4=0.008 mm/h² for the fourth 25 h. After that, a4 was kept until the end of the crystal growth.

The quality of the crystal after growth was evaluated by laser scanning of the crystal blank, and the result shows that the crystal blank is complete and transparent, with no obvious defects such as inclusions, clouds, bubbles, etc. therein. Thus, it can be concluded that the changes in the temperature gradient can be better adapted at different positions of the crucible (i.e., the compensation for the required temperature gradient increases gradually as the liquid surface drops) by controlling the induction coil to move with gradually increased acceleration in example 2. Therefore, the temperature field during the crystal growth process is stabilized in example 2, so that the temperature gradient for the crystal growth interface can be consistent with the temperature gradient in the initial state from the beginning of the descending of the liquid surface of the melt in the crucible, to the time when the liquid surface drops to the middle and the bottom of the crucible, thereby reducing defects generated during the crystal growth process.

It should be noted that the device for crystal growth of the present disclosure can achieve the various processes of the embodiment of the crystal growth method and can achieve the same technical effect. Thus, in order to avoid repetition, the above mentioned device will not be repeated in the embodiment.

the present disclosure also provides a crystal grown by the crystal growth method as described in the above embodiments.

It should be noted that the crystal provided in the present disclosure is a crystal grown by utilizing the method provided in the crystal growth method embodiments, and can achieve the same technical effect as the embodiments. Thus, in order to avoid repetition, the embodiment of the above mentioned crystal will not be described.

It should be noted that terms "including", "comprising", or any other variations thereof herein are intended to cover non-exclusive inclusion. Thus, a process, a method, an article, or a device comprising a series of elements includes not only the elements, but also other elements not explicitly listed, or other elements that are inherent to such process, method, article, or device. Without further limitation, the element defined by the phrase "including a ......" does not exclude the presence of another identical element in the process, method, article, or device that includes the element. In addition, it is noted that, within the scope of the method and device of the present disclosed embodiments, it is not limited that functions are performed in the shown or discussed order, but, it may also be included that the functions may also be performed in a substantially simultaneous manner or in an reverse order, depending on the functions involved. For example, the described methods may be performed in an order different from the described one, and various steps may be added, omitted, or combined. In addition, the features described with reference to some examples may be combined in other examples.

The embodiments and examples of the present disclosure are described above in conjunction with figures. However, the present disclosure is not limited to the above specific embodiments and examples which are merely illustrative without limitation. A person of ordinary skill in the art may make many various forms of embodiments and examples on the basis of the present disclosure without departing from the spirit of the present disclosure and the scope of protection of the claims. For example, the modification in which a certain embodiment or example is applied to other embodiment or example is within the scope of protection of the present disclosure. For example, when the crucible is not located at the middle-upper part of the induction coil, the trend of the longitudinal temperature distribution in the crucible may change. In this case, the speed or acceleration with which the induction coil moves downwards with respect to the crucible can be controlled according to the actual temperature distribution trend within the crucible, so that the temperature gradient close to that in the initial state is maintained during the descent of the liquid surface, preventing defects during the crystal growth process. As another example, the top of the induction coil can also be above the liquid surface of the melt when the induction coil stops moving. Thus, the temperature gradient at the liquid surface can be more appropriately compensated for by changes in the magnetic field strength from the induction coil.

## Claims

1. A crystal growth method, comprising:
controlling an induction coil to move downwards with respect to a crucible in a process of growing a crystal by using a pulling method, wherein:
the induction coil moves with an acceleration after the crystal enters an equal-diameter stage, and a moving speed of the induction coil tends to continuously increase during the entire moving process of the induction coil.

2. The crystal growth method according to claim 1, wherein,
the induction coil moves downwards with respect to the crucible with a variable acceleration during the entire moving process of the induction coil.

3. The crystal growth method according to claim 1, wherein,
the induction coil moves downwards with respect to the crucible with a constant acceleration during the entire moving process of the induction coil.

4. The crystal growth method according to claim 1, wherein,
a distance or time for which the induction coil moves with respect to the crucible is divided into a plurality of target sections in advance, and when the distance or time for which the induction coil moves with respect to the crucible reaches a target section, the induction coil is controlled to move at a constant speed corresponding to each of the target sections, wherein each of the target sections corresponds to a different speed, and a target section arranged later has a corresponding speed greater than that of a target section arranged earlier.

5. The crystal growth method according to claim 2, wherein,
a distance or time for which the induction coil moves with respect to the crucible is divided into a plurality of target sections in advance, and when the distance or time for which the induction coil moves with respect to the crucible reaches a target section, the induction coil is controlled to move with an uniform acceleration at the acceleration corresponding to the target section, wherein each of the target sections corresponds to a different acceleration.

6. The crystal growth method according to claim 5, wherein,
the target section arranged later has a corresponding acceleration greater than that of the target section arranged earlier.

7. The crystal growth method according to any one of claims 1 to 6, wherein,
the induction coil moves with respect to the crucible at a speed greater than or equal to 0.001 mm/h and less than or equal to 0.1 mm/h.

8. The crystal growth method according to claim 1, wherein,
a position of the liquid surface of the raw material melt of the crystal with respect to a bottom of the crucible when the induction coil begins to move is set as an initial position of the liquid surface,
an acceleration of the induction coil is set according to the initial position of the liquid surface, and
the higher the initial position of the liquid surface is, the greater the acceleration is.

9. The crystal growth method according to claim 1, wherein,
an acceleration of the induction coil is set according to the distance between the top of the induction coil and the liquid surface of the raw material melt of the crystal when the induction coil begins to move, and
the greater the distance is, the smaller the acceleration is.

10. A device for crystal growth, comprising:
a growth furnace having a growth furnace cavity within it;
a crucible provided within the growth furnace cavity, which can hold a crystal raw material;
an induction coil provided within the growth furnace cavity and surrounding the exterior of the crucible;
an induction coil drive mechanism connected to the induction coil to drive the induction coil to move downwards with respect to the crucible during crystal growth, such that:
the induction coil moves with an acceleration after the crystal enters an equal-diameter stage, and
a moving speed of the induction coil tends to continuously increase during the entire moving process of the induction coil.

11. The device for crystal growth according to claim 10, wherein, the induction coil drive mechanism comprises: a holder, a micro motion platform, and a motion mechanism;
the holder is provided below the induction coil, one end of the holder is connected to the induction coil, and the other end is connected to the micro motion platform by passing through the bottom of the growth furnace; wherein a bottom of the growth furnace is provided with an opening for the holder to pass through;
the micro motion platform is provided below the growth furnace, one side of the micro motion platform is connected to the holder, and the other side is connected to the motion mechanism; and
the motion mechanism is provided below the micro motion platform, and is capable of driving the moving of the micro motion platform, and when the micro motion platform moves, it is capable of driving the moving of the holder and the induction coil connected to the holder.

12. The device for crystal growth according to claim 11, wherein the motion mechanism is connected to the micro motion platform by a transmission mechanism.

13. The device for crystal growth according to any one of claims 10 to 12, wherein the device for crystal growth further comprises:
a heat-preservation furnace chamber provided within the growth furnace cavity,
the crucible is provided within the heat-preservation furnace chamber, and the induction coil surrounds the exterior of the heat-preservation furnace chamber.

14. A radiation detector comprising:
a substrate;
a scintillator provided on the substrate; and
a light detector for detecting the scintillation light emitted from the scintillator due to irradiation by radiation,
wherein the scintillator is obtained by cutting and grinding a crystal produced by the crystal growth method according to any one of claims 1 to 9.

15. A method of producing a scintillator for a radiation detector, comprising:
a step of obtaining a crystal blank, wherein the crystal blank is obtained according to the crystal growth method according to any one of claims 1 to 9;
a step of cutting, wherein a portion of the crystal blank having a uniform diameter is selected and cut to form one or more crystals having desired shapes; and
a step of grinding, wherein the one or more crystals obtained in the step of cutting are ground and polished, thereby obtaining the scintillator body for the radiation detector.
